# FASCICULE DE BREVET EUROPEEN

(11) **EP 3 171 182 B1**
(45) Date de publication et mention de la délivrance du brevet: **31.01.2018**
(21) Numéro de dépôt: 16198122.0
(22) Date de dépôt: 10.11.2016
(51) Int. Cl.: G01R 15/18, G01R 19/00, G01R 21/00, G05B 11/01, H02H 3/08

(54) **CAPTEUR DE COURANT ET DISPOSITIF POUR LA MESURE D'UN COURANT ÉLECTRIQUE**
STROMSENSOR UND VORRICHTUNG ZUM MESSEN EINES ELEKTRISCHEN STROMS
CURRENT SENSOR AND DEVICE FOR MEASURING AN ELECTRICAL CURRENT

(30) Priorité: 23.11.2015 FR 1561228
(43) Date de publication de la demande: 24.05.2017
(73) Titulaire: Schneider Electric Industries SAS, 92500 Rueil-Malmaison (FR)
(72) Inventeur: URANKAR, Lionel, 38050 Grenoble Cedex 09 (FR)
(74) Mandataire: Tripodi, Paul

(56) Documents cités:
- EP-A1- 1 596 206
- EP-A2- 0 838 686
- WO-A1-2013/037986
- FR-A1- 2 507 811
- US-A1- 2012 049 839
- US-B1- 6 313 623
- GERBER D ET AL: "IGBT gate-drive with PCB Rogowski coil for improved short circuit detection and current turn-off capability", PULSED POWER CONFERENCE (PPC), 2011 IEEE, IEEE, 19 juin 2011 (2011-06-19), pages 1359-1364, XP032173003, DOI: 10.1109/PPC.2011.6191615 ISBN: 978-1-4577-0629-5
- GERBER DOMINIC ET AL: "Gate Unit With Improved Short-Circuit Detection and Turn-Off Capability for 4.5-kV Press-Pack IGBTs Operated at 4-kA Pulse Current", IEEE TRANSACTIONS ON PLASMA SCIENCE, IEEE SERVICE CENTER, PISCATAWAY, NJ, US, vol. 41, no. 10, 1 octobre 2013 (2013-10-01), pages 2641-2648, XP011529105, ISSN: 0093-3813, DOI: 10.1109/TPS.2013.2280379 [extrait le 2013-10-07]
- RIGONI M ET AL: "Rogowski coil current meters", IEEE POTENTIALS, IEEE, NEW YORK, NY, US, vol. 27, no. 4, 1 janvier 2008 (2008-01-01), pages 40-45, XP011232250, ISSN: 0278-6648, DOI: 10.1109/MPOT.2008.924860

## Description

### DOMAINE TECHNIQUE

La présente invention est relative à un capteur destiné à la mesure d'un courant dans un conducteur électrique. Elle s'applique plus particulièrement à la mesure des courants alternatifs, en milieu industriel.

L'invention concerne aussi un appareil de mesure de puissance ou d'énergie électrique ou un appareil de protection ou de commande des circuits de distribution électrique tel qu'un disjoncteur ou contacteur, comportant au moins un tel capteur de courant.

### ETAT DE LA TECHNIQUE

Les capteurs de courant sont utilisés dans les appareils de mesure du courant, de la puissance ou de l'énergie électrique ainsi que dans les appareils de protection ou de contrôle des installations de distribution électrique comme les disjoncteurs, contacteurs, sectionneurs.

Parmi les capteurs de courant, l'utilisation de capteurs inductifs de type Rogowski est largement décrite dans la littérature.

Les capteurs de courant de type Rogowski comprennent un support en matériau amagnétique placé autour d'un conducteur électrique appelé aussi ligne de courant dans laquelle circule le courant à mesurer. Un fil conducteur est bobiné sur le support pour former un enroulement secondaire. L'ensemble forme un transformateur où ladite ligne de courant constitue un enroulement primaire et ledit enroulement secondaire fournit un signal de mesure représentatif de la dérivée du courant circulant dans la ligne de courant.

L'absence de noyau magnétique risquant d'être saturé par le champ magnétique généré par le courant dans la ligne de courant, permet au capteur d'avoir une très bonne linéarité de réponse sur une large dynamique de courant primaire. Cette qualité présente un grand intérêt pour la mesure de courant.

En contrepartie, le champ magnétique généré dans l'enroulement secondaire par le courant circulant dans la ligne de courant est beaucoup plus faible que dans le cas d'un capteur comportant un circuit magnétique ce qui rend le capteur de Rogowski plus sensible aux perturbations électromagnétiques externes, par exemple aux champs générés par une autre ligne de courant placée à l'extérieur du support, à proximité du capteur. Cette sensibilité aux perturbations externes sera d'autant plus importante que le courant à mesurer dans le conducteur primaire sera faible, le rapport signal sur bruit étant, dans ce cas, lui aussi faible. D'autre part, une forme polygonale, en particulier rectangulaire ou carrée est mieux adaptée qu'une forme circulaire classique du capteur de Rogowski pour une implantation dans un dispositif de mesure, généralement de forme parallélépipédique car l'espace est mieux rempli. Le gain d'un tore de Rogowski étant proportionnel au nombre de spires et à la surface de chaque spire, il est possible de maximiser le gain d'un capteur de forme polygonale :
- en utilisant une section de spire rectangulaire ou carrée, la surface de chaque spire sera supérieure à celle d'une spire ronde de diamètre égal au côté du carré ou du rectangle équivalent,
- en utilisant un support carré ou rectangulaire, le périmètre moyen du capteur sera supérieur au périmètre d'un support circulaire d'encombrement équivalent, et donc, à épaisseur de bobinage équivalent, il sera possible de bobiner un plus grand nombre de spire sur le support carré ou rectangulaire.

Cependant, pour un tel capteur polygonal, il n'est plus possible de maintenir constant le nombre de spires par unité de longueur au niveau des angles puisqu'ils représentent des points de forte discontinuité et il est connu que pour minimiser l'influence des champs électromagnétiques externes, il est nécessaire que le pas de bobinage soit constant sur toute la longueur de l'enroulement.

On connait différents modes de réalisation ayant pour objet de résoudre ce dilemme: le brevet EP1596206 décrit un dispositif de mesure de courant comprenant un enroulement secondaire formé par au moins trois bobinages dont l'inductance locale d'au moins une des extrémités est supérieure à l'inductance locale vers la partie centrale des bobinages.

Le brevet EP0838686 décrit un dispositif de mesure de courant comprenant un enroulement secondaire formé par au moins quatre bobinages. Une compensation du manque de spires au niveau des angles est effectuée en agençant les quatre bobinages de manière à ce que chaque extrémité de bobinage soit recouverte partiellement ou totalement par le bobinage qui lui est adjacent.

Ces solutions ne répondent pas entièrement au problème lié à l'influence de flux extérieurs sur la mesure de courant électrique, en particulier dans le cas d'une installation électrique triphasée très déséquilibrée par des charges monophasées, et plus particulièrement pour obtenir une précision de mesure accrue dans le cas de la mesure d'un courant faible dans le conducteur primaire.

### EXPOSE DE L'INVENTION

L'invention vise donc à remédier aux inconvénients de l'état de la technique en proposant un dispositif de mesure d'un courant électrique, capable de délivrer un signal adapté pour une mesure précise du courant, très peu sensible aux perturbations électromagnétiques extérieures et de forme adaptée à une implantation dans un appareillage industriel compact.

Un capteur de courant selon l'invention comporte au moins deux couches de bobines entourant un conducteur de courant pour effectuer une mesure d'un courant circulant dans ledit conducteur:
- une première couche de bobines comporte plusieurs enroulements reliés entre eux, chaque enroulement ayant un axe de bobinage longitudinal disposé dans un premier plan, le croisement des axes formant des zones d'angle correspondant aux sommets d'un premier polygone, chaque axe de bobinage formant un côté dudit premier polygone, .
- une seconde couche de bobines comporte plusieurs enroulements reliés entre eux, chaque enroulement ayant un axe de bobinage longitudinal disposé dans un second plan, parallèle au premier plan, le croisement des axes formant des zones d'angle correspondant aux sommets d'un second polygone, chaque axe de bobinage formant un côté dudit second polygone.

Chaque enroulement de chacune des couches d'enroulements est constitué par des spires orientées sensiblement perpendiculairement à l'axe de bobinage.

Le premier polygone comporte plusieurs zones d'angle, chacune des zones d'angle étant formée par un sommet du polygone.

Le second polygone est de forme identique au premier polygone et comporte de même plusieurs zones d'angle, chacune des zones d'angle étant formée par un sommet du second polygone.

Les premier et second polygones sont placés en vis-à-vis de telle sorte que chaque zone d'angle du premier polygone est respectivement située en face de chaque zone d'angle correspondante du seconde polygone.

Dans chaque zone d'angle, l'orientation des spires de l'enroulement de la première couche de bobines est différente de l'orientation des spires de l'enroulement de la seconde couche de bobines dans la zone d'angle en vis-à-vis. Chaque zone d'angle est occupée par une extrémité d'un seul enroulement et une extrémité d'un enroulement adjacent s'étend sensiblement jusqu'à un côté de l'enroulement occupant ladite zone d'angle.

Le premier polygone comporte plusieurs zones sensiblement rectilignes, chacune des zones rectilignes étant formée par un côté dudit polygone. De la même façon, le second polygone comporte aussi plusieurs zones sensiblement rectilignes, chacune des zones rectilignes étant formée par un côté du second polygone. Chaque zone rectiligne de la première couche de bobines est respectivement située en vis-à-vis d'une zone rectiligne correspondante de la seconde couche de bobines. L'axe de bobinage des enroulements de la première couche de bobines dans chaque zone rectiligne du premier support est parallèle à l'axe de bobinage des enroulements de la seconde couche de bobines dans la zone rectiligne en vis-à-vis du second support.

Les enroulements de la première couche de bobines et de la seconde couche de bobines du capteur de courant sont enroulés chacun sur un support de type non magnétique. Le pas de bobinage des enroulements de la première couche de bobines et des enroulements de la seconde couche de bobines est sensiblement constant.

Les enroulements de la première couche de bobines sont reliés en série et les enroulements de la seconde couche de bobines sont reliés en série.

Le sens de bobinage des enroulements de la première couche de bobines est préférentiellement inversé par rapport au sens de bobinage des enroulements de la seconde couche de bobines.

La forme des premier et second polygones est préférentiellement un rectangle ou un carré. Selon ce mode de réalisation, dans chaque zone d'angle, les spires de l'enroulement de la première couche de bobines sont orientées sensiblement à angle droit par rapport aux spires de l'enroulement de la seconde couche de bobines dans la zone d'angle en vis-à-vis.

Les bobines du capteur de courant peuvent être réalisées selon une technique de circuit imprimé, de dépôt par sérigraphie de matériau conducteur sur un support isolant ou encore par impression en trois dimensions, cette liste étant non limitative.

Selon l'invention, un appareil de mesure de puissance ou d'énergie électrique, tel qu'un ampèremètre ou un wattmètre, comporte au moins un capteur de courant. Préférentiellement, une première extrémité de la première couche de bobines est reliée à un potentiel de référence de l'appareil de mesure, une seconde extrémité de la première couche de bobines est reliée à une première entrée d'un amplificateur, préférentiellement de type amplificateur différentiel, une première extrémité de la seconde couche de bobines est reliée audit potentiel de référence de l'appareil de mesure et une seconde extrémité de la seconde couche de bobines est reliée à une seconde entrée de l'amplificateur. Au moins un circuit de traitement est connecté à au moins un capteur de courant, ledit circuit de traitement étant adapté pour effectuer la mesure d'un signal représentatif du courant circulant dans le conducteur de courant.

Un déclencheur électrique selon l'invention, comporte au moins un capteur de courant et au moins un circuit de traitement connecté audit capteur de courant pour recevoir au moins un signal représentatif du courant circulant dans le conducteur de courant.

Un dispositif de coupure comporte un déclencheur électrique comprenant au moins un capteur selon l'invention, un mécanisme d'ouverture des contacts électriques, le déclencheur électrique étant relié au mécanisme d'ouverture afin d'ouvrir les contacts du dispositif de coupure.

### BREVE DESCRIPTION DES DESSINS

D'autres avantages et caractéristiques ressortiront plus clairement de la description qui va suivre, de modes particuliers de réalisation de l'invention, donnés à titre d'exemples non limitatifs, et représentés aux dessins annexés sur lesquels :
- la figure 1 représente une vue en perspective du capteur selon un mode de réalisation préférentiel ;
- les figures 2A et 2B représentent une forme polygonale préférentielle du capteur.
- les figures 3A et 3B représentent des vues de dessus de l'implantation des spires de deux couches de bobines du capteur dans deux zones d'angle en vis-à-vis ;
- les figures 3C et 3D représentent des vues de dessus d'une variante de l'implantation des spires de deux couches de bobines du capteur dans deux zones d'angle en vis-à-vis ;
- les figures 4A et 4B représentent, en vue de dessus, un premier mode de réalisation d'une première et seconde couche de bobines ;
   -- les figures 5A et 5B représentent, en vue de dessus, un second mode de réalisation d'une première et seconde couche de bobines ;
   -- la figure 6 représente un schéma bloc d'un appareil de mesure intégrant un capteur de courant selon l'invention ;
- la figure 7 représente un schéma bloc d'un dispositif de coupure intégrant plusieurs capteurs de courant selon l'invention.

### DESCRIPTION DETAILLEE DE MODES DE REALISATION PREFERES

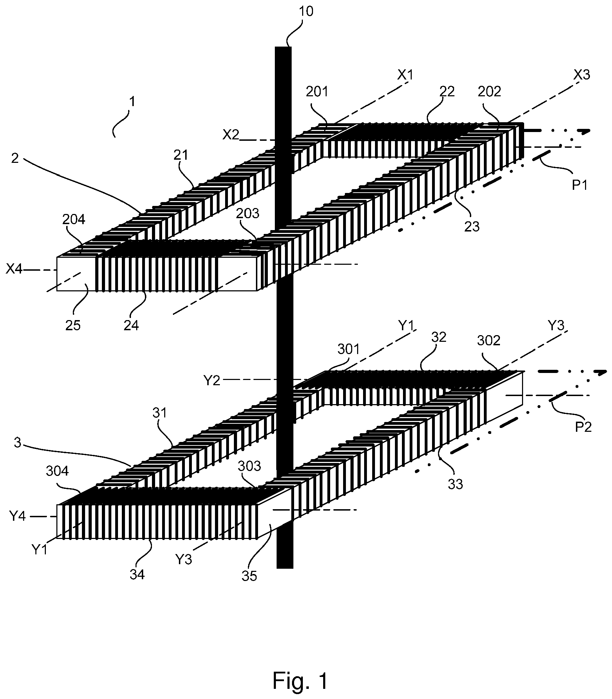

Selon le mode de réalisation préféré de l'invention représenté sur la figure 1, le capteur de courant 1 comporte une première couche de bobines 2 et une seconde couche de bobines 3 disposées autour de la ligne de courant 10. Le courant à mesurer circule dans la ligne de courant 10.

La première couche de bobines 2 comporte plusieurs enroulements 21, 22, 23, 24, réalisés par bobinage d'un fil conducteur sur un support 25. Lesdits enroulements sont reliés électriquement en série. L'enroulement 21 est bobiné selon un axe X1, l'enroulement 22 est bobiné selon un axe X2, l'enroulement 23 est bobiné selon un axe X3, l'enroulement 24 est bobiné selon un axe X4 Les axes X1, X2, X3, X4 sont disposés dans un même plan P1.

Les axes X1, X2, X3, X4 sont sensiblement rectilignes, X1 est sensiblement perpendiculaire à X2 et à X4, X3 est sensiblement perpendiculaire à X2 et à X4.

La seconde couche de bobines 3 comporte plusieurs enroulements 31, 32, 33, 34, réalisés par bobinage d'un fil conducteur sur un support 35. Lesdits enroulements sont reliés électriquement en série. L'enroulement 31 est bobiné selon un axe Y1, l'enroulement 32 est bobiné selon un axe Y2, l'enroulement 33 est bobiné selon un axe Y3, l'enroulement 34 est bobiné selon un axe Y4. Les axes Y1, Y2, Y3, Y4 sont disposés dans un même plan P2.

Les axes Y1, Y2, Y3, Y4 sont sensiblement rectilignes, Y1 est sensiblement perpendiculaire à Y2 et à Y4, Y3 est sensiblement perpendiculaire à Y2 et à Y4. La première couche de bobines 2 et la seconde couche de bobines 3 sont placées à proximité l'une de l'autre, préférentiellement le plus près possible, le plan P1 étant sensiblement parallèle au plan P2.

L'axe X1 est sensiblement parallèle à l'axe Y1, l'axe X2 est sensiblement parallèle à l'axe Y2, l'axe X3 est sensiblement parallèle à l'axe Y3 et l'axe X4 est sensiblement parallèle à l'axe Y4.

Les supports 25 et 35 sont préférentiellement identiques en forme et en dimensions afin que les spires de la couche de bobines 2 soient identiques aux spires de la couche de bobines 3. Les supports 25 et 35 sont aussi préférentiellement identiques en composition.

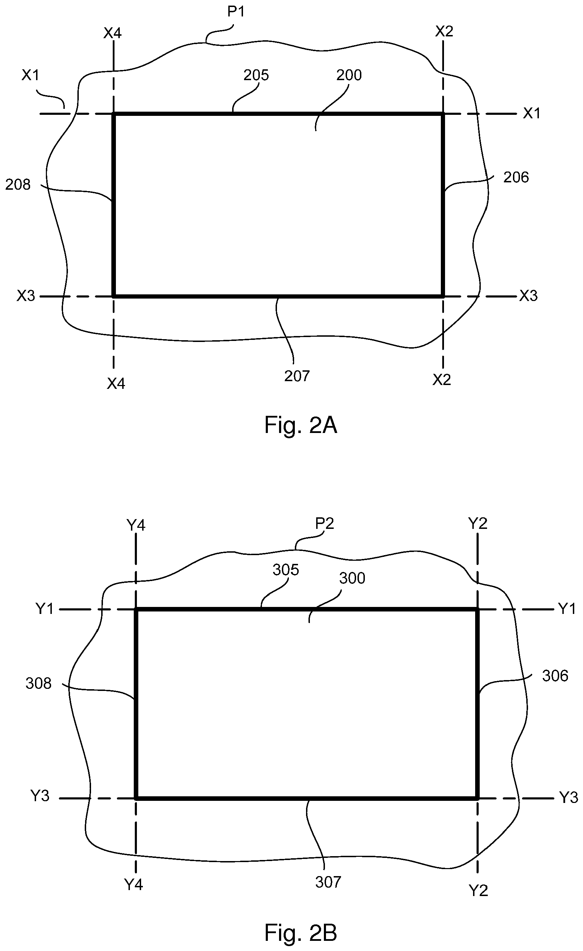

Selon la figure 2A, les axes X1, X2, X3, X4 forment le contour d'un premier polygone 200, préférentiellement un rectangle. Ledit polygone 200 comporte quatre côtés : 205, 206, 207 et 208. Un premier côté 205 du polygone 200 est formé selon l'axe X1, un deuxième côté 206 du polygone 200 est formé selon l'axe X2, un troisième côté 207 du polygone 200 est formé selon l'axe X3 et un quatrième côté 208 du polygone 200 est formé selon l'axe X4. Ce contour forme aussi la longueur de la couche de bobines 2.

Selon la figure 2B, les axes Y1, Y2, Y3, Y4 forment le contour d'un second polygone 300, préférentiellement un rectangle. Ledit polygone 300 comporte quatre côtés : 305, 306, 307 et 308. Un premier côté 305 du polygone 200 est formé selon l'axe Y1, un deuxième côté 306 du polygone 200 est formé selon l'axe Y2, un troisième côté 307 du polygone 200 est formé selon l'axe Y3 et un quatrième côté 308 du polygone 200 est formé selon l'axe Y4. Ce contour forme aussi la longueur de la couche de bobines 3.

Selon le mode de réalisation préférentiel représenté sur la figure 1, la première couche de bobines 2 comporte quatre zones d'angle. Une première zone d'angle 201 est localisée dans la zone d'intersection entre les axes X1 et X2, une deuxième zone d'angle 202 est localisée dans la zone d'intersection entre les axes de bobinage X2 et X3, une troisième zone d'angle 203 est localisée dans la zone d'intersection entre les axes de bobinage X3 et X4, et une quatrième zone d'angle 204 est localisée dans la zone d'intersection entre les axes de bobinage X1 et X4.

De la même façon, selon le mode de réalisation préférentiel, la deuxième couche de bobines 3 comporte quatre zones d'angle. Une première zone d'angle 301 est localisée dans la zone d'intersection entre les axes Y1 et Y2, une deuxième zone d'angle 302 est localisée dans la zone d'intersection entre les axes de bobinage Y2 et Y3, une troisième zone d'angle 303 est localisée dans la zone d"intersection entre les axes de bobinage Y3 et Y4, et une quatrième zone d'angle 404 est localisée dans la zone d'intersection entre les axes de bobinage Y1 et Y4.

Les zones d'angle 201 et 301 sont en vis-à-vis. Il en est de même pour les zones d'angle respectivement 202 et 302, 203 et 303, 204 et 304.

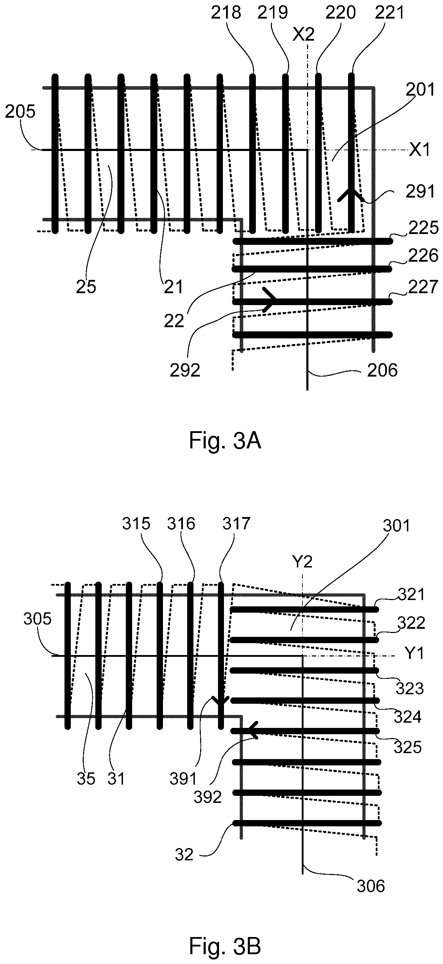

La figure 3A représente, selon un mode de réalisation préféré, une vue de dessus de l'implantation des enroulements 21 et 22 dans la zone d'angle 201 de la première couche de bobines 2. Les spires 218 à 221 du premier enroulement 21 sont bobinées selon l'axe X1. L'orientation des spires dans la zone d'angle 201 est perpendiculaire à l'axe X1. Préférentiellement, Nangle spires 220 à 221 sont bobinées selon l'axe X1, à l'extrémité de l'enroulement 21, dans la zone d'angle 201.

La zone d'angle 201 étant occupée par l'enroulement 21, une extrémité de l'enroulement 22 s'étend sensiblement jusqu'à un côté de l'enroulement 21. La spire 225 située à l'extrémité de l'enroulement 22 ainsi que les autres spires de l'enroulement 22 sont orientées perpendiculairement par rapport aux spires 218 à 221 de l'enroulement 21.

Il apparait donc que le nombre de spires par unité de longueur selon l'axe X2 n'est pas constant sur le contour du polygone 200 : préférentiellement, les axes de bobinage X1 et X2 étant aussi axes de symétrie du support 25, il manque par conséquent Nangle spires à l'enroulement 22 selon l'axe X2.

La figure 3B représente, selon un mode de réalisation préféré, une vue de dessus de l'implantation des enroulements 31 et 32 de la seconde couche de bobines 3, dans la zone d'angle 301, située en vis-à-vis de la zone d'angle 201. Les spires 321, 322, 323, 324 du second enroulement 32, bobinées selon l'axe Y2, occupent la zone d'angle 301. L'orientation des spires dans la zone d'angle 301 est perpendiculaire à l'axe Y2. Préférentiellement, Nangle spires 321, 322 sont bobinées selon l'axe Y2, avant les spires 323, 324.

La zone d'angle 301 étant occupée par l'enroulement 32, une extrémité de l'enroulement 31 s'étend sensiblement jusqu'à un côté de l'enroulement 32. La spire 317 située à l'extrémité de l'enroulement 31 ainsi que les autres spires 316, 315 de l'enroulement 31 sont orientées sensiblement perpendiculairement par rapport aux spires 321, 322, 323, 324 de l'enroulement 32.

Il apparait donc que le nombre de spires par unité de longueur selon l'axe Y1 n'est pas constant sur le contour du polygone 300 ; préférentiellement, les axes de bobinage Y1 et Y2 étant aussi axes de symétrie du support 35, il manque par conséquent Nangle spires à l'enroulement 31 selon l'axe Y1.

Dans la zone d'angle 201, l'enroulement 21 compte Nangle spires 220, 221 en dehors du contour du polygone 200 alors que l'enroulement 22 ne comporte aucune spire dans cette même zone.

Dans la zone d'angle 301, l'enroulement 31 ne comporte aucune spire alors que l'enroulement 32 compte Nangle spires (321, 322) en dehors du contour du polygone 300 dans cette même zone.

L'enroulement 21 étant en vis-à-vis de l'enroulement 31, les axes X1 et Y1 étant parallèles, les Nangle spires 220, 221 de l'enroulement 21 dans la zone d'angle 201 en dehors du contour du polygone 200 captent sensiblement le même champ magnétique que les spires 316, 317 de l'enroulement 3 ce qui compense le manque de spires de l'enroulement 31 dans la zone d'angle 301.

Il en est de même pour les enroulements 22 et 32 : l'enroulement 22 étant en vis-à-vis de l'enroulement 32, et les axes X2 et Y2 étant parallèles, les Nangle spires 321, 322 de l'enroulement 32 dans la zone d'angle 301 en dehors du contour du polygone 300 captent sensiblement le même champ magnétique que les spires 225, 226 de l'enroulement 2 ce qui compense le manque de spires de l'enroulement 22 dans la zone d'angle 201.

Une extrémité de l'enroulement 21 de la première couche de bobines 2 occupe la zone d'angle 201, les spires sont orientées perpendiculairement à l'axe X1. Une extrémité de l'enroulement 32 de la seconde couche de bobines 3 occupe la zone d'angle 301, les spires sont orientées perpendiculairement à l'axe Y2. Les zones d'angle 201 et 301 étant en vis-à-vis, X1 étant perpendiculaire à Y2, l'orientation des spires de l'enroulement 21 de la première couche de bobines 2 est différente de l'orientation des spires de l'enroulement 32 de la seconde couche de bobines 3. Selon le mode de réalisation préférentiel représenté en figure 1, les spires de l'enroulement 21 dans la zone d'angle 201 de la première couche de bobines 2 sont orientées sensiblement à angle droit par rapport aux spires de l'enroulement 32 dans la zone d'angle 301 de la seconde couche de bobines 3.

Ainsi donc, la position en vis-à-vis des couches de bobines 2, 3 associée à la disposition astucieuse des enroulements 21, 22, 31, 32 dans les zones d'angle en vis-à-vis 201, 301 permet d'obtenir un effet équivalent à un pas de bobinage constant dans lesdites zone d'angle. Le pas de bobinage étant constant sur les côtés des polygones 200, 300, le pas de bobinage est donc constant sur toute la longueur des couches de bobines 2, 3. Le capteur ainsi réalisé présente une grande insensibilité aux champs électromagnétiques externes tout en étant simple et économique à réaliser.

La disposition particulière des spires des enroulements 21, 22, 31, 32 dans les zones d'angles 201 et 301 telle que décrite précédemment est reproduite pour les enroulements 22, 23, 32, 33 dans les zones d'angles 202 et 302, pour les enroulements 23, 24, 33, 34 dans les zones d'angles 203 et 303, et pour les enroulements 21, 24, 31, 34 dans les zones d'angles 204 et 304.

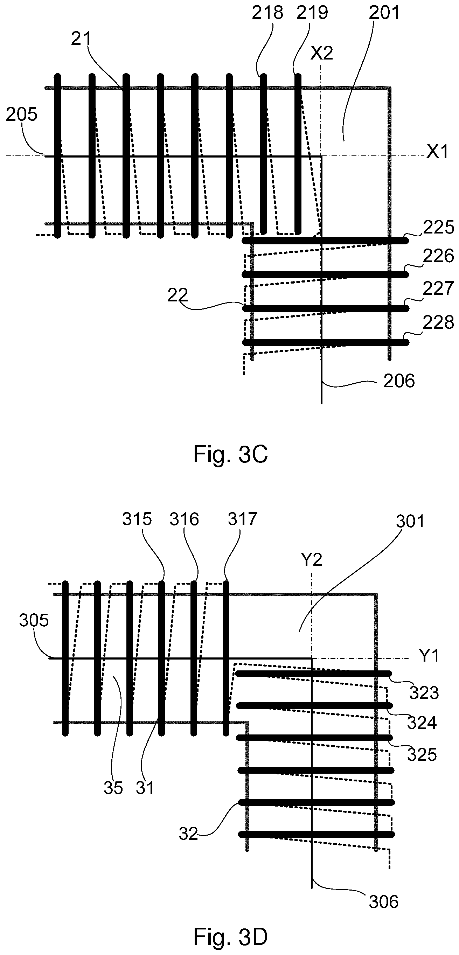

La figure 3C, représente une vue de dessus d'une variante d'implantation des spires des enroulements 21 et 22 dans la zone d'angle 201 de la première couche de bobines 2. Les spires 218 à 219 du premier enroulement 21 sont bobinées selon le côté 205 du polygone 200, selon l'axe X1. L'orientation des spires dans la zone d'angle 201 est perpendiculaire à l'axe X1. La zone d'angle 201 étant occupée par l'enroulement 21, la spire 225 située à une extrémité de l'enroulement 22 s'étend sensiblement jusqu'à un côté de l'enroulement 21. La spire 225 située à l'extrémité de l'enroulement 22 ainsi que les autres spires de l'enroulement 22 sont orientées perpendiculairement par rapport aux spires 218 à 219 de l'enroulement 21. Il apparait donc que le nombre de spires par unité de longueur selon l'axe X2 n'est pas constant sur le contour du polygone 200 : préférentiellement, les axes de bobinage X1 et X2 étant aussi axes de symétrie du support 25, il manque par conséquent Nangle spires à l'enroulement 22 selon l'axe X2.

La figure 3D représente une vue de dessus d'une variante d'implantation des spires des enroulements 31 et 32 de la seconde couche de bobines 3, dans la zone d'angle 301, située en vis-à-vis de la zone d'angle 201. Les spires 323, 324 du second enroulement 32, bobinées selon l'axe Y2, selon le côté 306 du polygone 300, occupent la zone d'angle 301.

La zone d'angle 301 étant occupée par l'enroulement 32, la spire 317 située à une extrémité de l'enroulement 31 s'étend sensiblement jusqu'à un côté de l'enroulement 32.

Ainsi dans les zones d'angle en vis-à-vis 201, 301, l'orientation des spires de l'enroulement 21 de la première couche de bobines 2 est différente de l'orientation des spires de l'enroulement 32 de la seconde couche de bobines 3. Selon le mode de réalisation représenté en figure 3C et 3D, les spires de l'enroulement 21 dans la zone d'angle 201 de la première couche de bobines 2 sont orientées sensiblement à angle droit par rapport aux spires de l'enroulement 32 dans la zone d'angle 301 de la seconde couche de bobines 3.

La disposition particulière des spires des enroulements 21, 22, 31, 32 dans les zones d'angles 201 et 301 telle que décrite précédemment est reproduite pour les enroulements 22, 23, 32, 33 dans les zones d'angles 202 et 302, pour les enroulements 23, 24, 33, 34 dans les zones d'angles 203 et 303, et pour les enroulements 21, 24, 31, 34 dans les zones d'angles 204 et 304.

Cette variante de disposition est adoptée lorsque des impératifs de réalisation technique s'opposent à la réalisation d'un pas de bobinage constant des spires dans la zone d'angle.

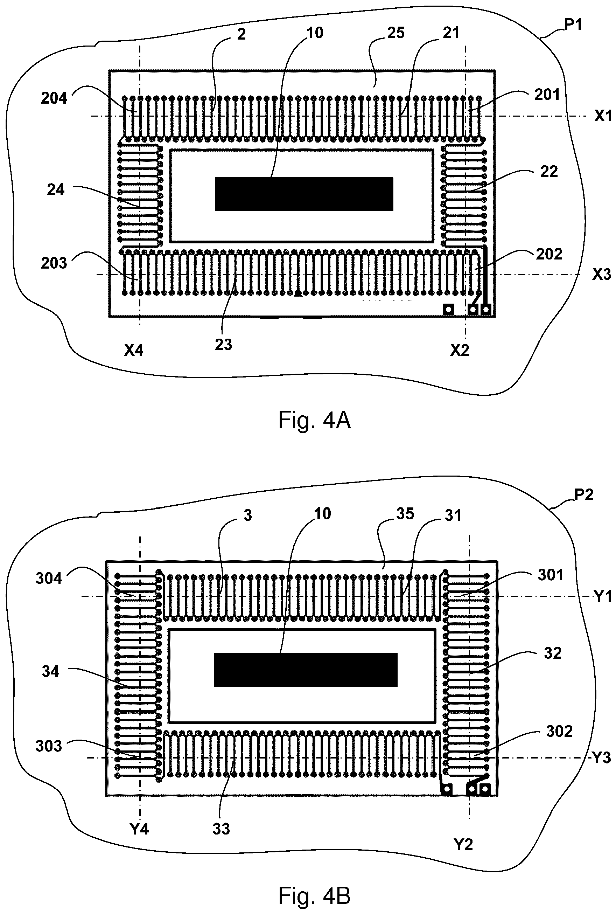

La figure 4A représente un premier mode de réalisation de la couche de bobines 2 de l'invention et la figure 4B représente un premier mode de réalisation de la couche de bobines 3 de l'invention. Le support 25 de la couche de bobines 2 et le support 35 de la couche de bobines 3 sont réalisés sous forme de circuits imprimés, préférentiellement double face.

Les couches de bobines 2 et 3 sont destinées à être superposées, la zone d'angle 201 venant en vis-à-vis de la zone d'angle 301, la zone d'angle 202 venant en vis-à-vis de la zone d'angle 302, la zone d'angle 203 venant en vis-à-vis de la zone d'angle 303 et la zone d'angle 204 venant en vis-à-vis de la zone d'angle 304. Une extrémité de l'enroulement 21 de la première couche de bobines 2 occupe la zone d'angle 201, les spires sont orientées perpendiculairement à l'axe X1. Une extrémité de l'enroulement 32 de la seconde couche de bobines 3 occupe la zone d'angle 301, les spires sont orientées perpendiculairement à l'axe Y2. X1 étant perpendiculaire à Y2, l'orientation des spires de l'enroulement 21 de la première couche de bobines 2 est différente de l'orientation des spires de l'enroulement 32 de la seconde couche de bobines 3 dans les zones d'angle 201 et 301 en vis-à-vis.

Une extrémité de l'enroulement 23 de la première couche de bobines 2 occupe la zone d'angle 202, les spires sont orientées perpendiculairement à l'axe X3. Une extrémité de l'enroulement 32 de la seconde couche de bobines 3 occupe la zone d'angle 302, les spires sont orientées perpendiculairement à l'axe Y2. X3 étant perpendiculaire à Y2, l'orientation des spires de l'enroulement 23 de la première couche de bobines 2 est différente de l'orientation des spires de l'enroulement 32 de la seconde couche de bobines 3 dans les zones d'angle 202 et 302 en vis-à-vis.

Une extrémité de l'enroulement 23 de la première couche de bobines 2 occupe la zone d'angle 203, les spires sont orientées perpendiculairement à l'axe X3. Une extrémité de l'enroulement 34 de la seconde couche de bobines 3 occupe la zone d'angle 303, les spires sont orientées perpendiculairement à l'axe Y4. X3 étant perpendiculaire à Y4, l'orientation des spires de l'enroulement 23 de la première couche de bobines 2 est différente de l'orientation des spires de l'enroulement 34 de la seconde couche de bobines 3 dans les zones d'angle 203 et 303 en vis-à-vis.

Une extrémité de l'enroulement 21 de la première couche de bobines 2 occupe la zone d'angle 204, les spires sont orientées perpendiculairement à l'axe X1. Une extrémité de l'enroulement 34 de la seconde couche de bobines 3 occupe la zone d'angle 304, les spires sont orientées perpendiculairement à l'axe Y4. X1 étant perpendiculaire à Y4, l'orientation des spires de l'enroulement 21 de la première couche de bobines 2 est différente de l'orientation des spires de l'enroulement 34 de la seconde couche de bobines 3 dans les zones d'angle 204 et 304 en vis-à-vis.

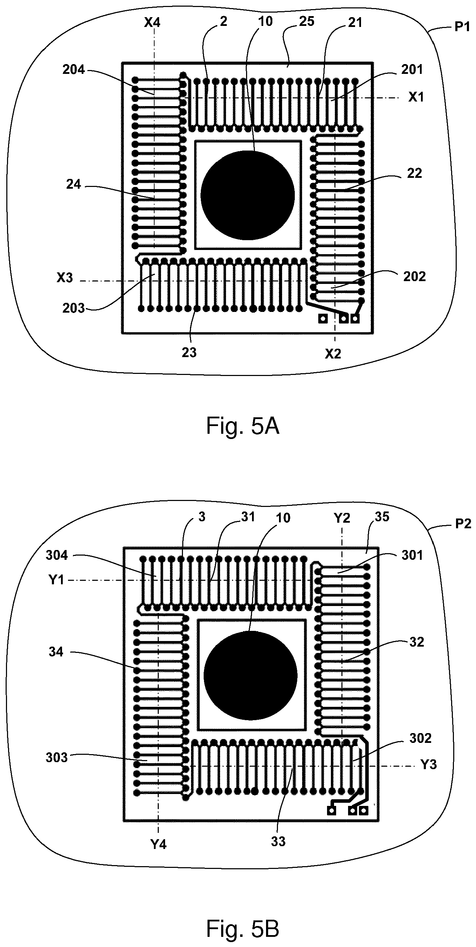

Il est possible de créer de multiples variantes de réalisation des couches de bobines 2, 3 en bobinant selon un des deux axes dans chaque zone d'angle d'une des couches de bobines et en bobinant selon l'autre des deux axes de la zone d'angle en vis-à-vis de façon a obtenir une orientation des spires de l'enroulement de la première couche de bobines 2 différente de l'orientation des spires de l'enroulement de la seconde couche de bobines 3. On obtient ainsi une disposition en quinconce des enroulements de chaque couche de bobinage dans chaque zone d'angle en vis-à-vis
La figure 5A représente un autre mode de réalisation de la couche de bobines 2, la figure 5B représente un autre mode de réalisation de la couche de bobines 3. Le premier polygone 200 et le second polygone 300 sont des carrés. La ligne de courant 10 est de section circulaire, par exemple dans le cas ou la ligne de courant est un câble électrique.

Les couches de bobines 2 et 3 sont destinées à être superposées, la zone d'angle 201 venant en vis-à-vis de la zone d'angle 301, la zone d'angle 202 venant en vis-à-vis de la zone d'angle 302, la zone d'angle 203 venant en vis-à-vis de la zone d'angle 303 et la zone d'angle 204 venant en vis-à-vis de la zone d'angle 304. Une extrémité de l'enroulement 21 de la première couche de bobines 2 occupe la zone d'angle 201, les spires sont orientées perpendiculairement à l'axe X1. Une extrémité de l'enroulement 32 de la seconde couche de bobines 3 occupe la zone d'angle 301, les spires sont orientées perpendiculairement à l'axe Y2. X1 étant perpendiculaire à Y2, l'orientation des spires de l'enroulement 21 de la première couche de bobines 2 est différente de l'orientation des spires de l'enroulement 32 de la seconde couche de bobines 3 dans les zones d'angle respectivement 201 et 301 en vis-à-vis.

Une extrémité de l'enroulement 22 de la première couche de bobines 2 occupe la zone d'angle 202, les spires sont orientées perpendiculairement à l'axe X2. Une extrémité de l'enroulement 33 de la seconde couche de bobines 3 occupe la zone d'angle 302, les spires sont orientées perpendiculairement à l'axe Y3. X2 étant perpendiculaire à Y3, l'orientation des spires de l'enroulement 22 de la première couche de bobines 2 est différente de l'orientation des spires de l'enroulement 33 de la seconde couche de bobines 3 dans les zones d'angle respectivement 202 et 302 en vis-à-vis.

Une extrémité de l'enroulement 23 de la première couche de bobines 2 occupe la zone d'angle 203, les spires sont orientées perpendiculairement à l'axe X3. Une extrémité de l'enroulement 34 de la seconde couche de bobines 3 occupe la zone d'angle 303, les spires sont orientées perpendiculairement à l'axe Y4. X3 étant perpendiculaire à Y4, l'orientation des spires de l'enroulement 23 de la première couche de bobines 2 est différente de l'orientation des spires de l'enroulement 34 de la seconde couche de bobines 3 dans les zones d'angle respectivement 203 et 303 en vis-à-vis.

Une extrémité de l'enroulement 24 de la première couche de bobines 2 occupe la zone d'angle 204, les spires sont orientées perpendiculairement à l'axe X4. Une extrémité de l'enroulement 31 de la seconde couche de bobines 3 occupe la zone d'angle 304, les spires sont orientées perpendiculairement à l'axe Y1. X4 étant perpendiculaire à Y1, l'orientation des spires de l'enroulement 24 de la première couche de bobines 2 est différente de l'orientation des spires de l'enroulement 31 de la seconde couche de bobines 3 dans les zones d'angle respectivement 204 et 304 en vis-à-vis.

L'invention n'est pas limitée aux modes de réalisation présentés en figures 4A, 4B, 5A et 5B. D'autres formes peuvent être choisies pour le premier polygone 200 et le second polygone 300 : trapèze, pentagone, hexagone, octogone, cette liste n'étant nullement limitative. Par exemple dans le cas d'un pentagone régulier, les spires de l'enroulement occupant la zone d'angle 201 de la première couche de bobines 2 sont orientées sensiblement à 108° par rapport aux spires de l'enroulement occupant la zone d'angle 301 de la seconde couche de bobines 3. L'orientation sera sensiblement de 135° dans le cas d'un octogone régulier.

Les exemples des figures 1, 4A, 4B, 5A, 5B montrent un capteur avec deux couches de bobines 2, 3 mais, en variante, afin d'obtenir plus de tension V délivrée par l'enroulement secondaire du capteur de courant 1, plusieurs couches de bobines 2 et plusieurs couches de bobines 3 peuvent être assemblées entre elles, dans la mesure où le nombre de couches de bobines 2 est égal au nombre de couches de bobines 3. Dans cette configuration, les couches de bobines 2 sont reliées électriquement en série entre elles formant ainsi l'équivalent d'une seule première couche de bobines 2 et les couches de bobines 3 sont reliées électriquement en série entre elles, formant ainsi l'équivalent d'une seule seconde couche de bobines 3. Le nombre de spires N du capteur résultant sera égal à la somme du nombre de spires de la première couche de bobines 2 et du nombre de spires de la seconde couche de bobines 3 présentes dans l'assemblage.

Le sens de bobinage de la première couche de bobines 2 est préférentiellement inversé par rapport au sens de bobinage de la seconde couche de bobines 3. Sur la figure 3A, la flèche 291 sur la spire 221 de l'enroulement 21 et la flèche 292 sur la spire 227 de l'enroulement 22 indiquent le sens de bobinage de la couche de bobines 2. Sur la figure 3B, la flèche 391 sur la spire 317 de l'enroulement 31 et la flèche 392 sur la spire 325 de l'enroulement 32 indiquent le sens de bobinage de la couche de bobines 3. Cette disposition reproduite sur l'ensemble des couches de bobines 2 et 3 permet de s'affranchir de spire de compensation, la couche de bobines 2 compensant l'effet de boucle de la couche de bobines 3 et réciproquement la couche de bobines 3 compensant l'effet de boucle de la couche de bobines 2.

Les supports de bobinage 25, 35 sont réalisés en matériau amagnétique. Ils peuvent être creux ou pleins, rigides ou semi-rigides, de section transversale cylindrique, carrée, rectangulaire ou ovoïde, réalisé sous forme monobloc ou par morceaux assemblés entre eux.

Chaque couche de bobines 2, 3 peut être réalisée en utilisant la technologie du circuit imprimé, les supports 25, 35 étant en matériau conventionnellement utilisé par cette technologie par exemple de l'epoxy, de la fibre de verre ou une céramique, sur lesquels sont déposées, sérigraphiées ou gravées des pistes formant l'enroulement. La continuité de l'enroulement entre les deux faces de chaque support 25, 35 est réalisée par des trous métallisés, appelé aussi « vias ». La liaison électrique entre les différents bobinages est assurée par des pistes formées selon la même méthode que l'enroulement. Le circuit imprimé utilisé est préférentiellement double face. Il est possible d'utiliser un circuit imprimé multicouches.

Dans un autre mode de réalisation particulier, chaque couche de bobines 2, 3 du capteur de courant 1 est réalisée par un dépôt de matériau conducteur de l'électricité (par exemple du cuivre) sur un support respectivement 25, 35 en matériau isolant (par exemple un matériau polymère (comme du polyamide ou du polycarbonate) ou de la céramique ou encore du verre) au moyen d'une technique de sérigraphie.

Dans un autre mode de réalisation particulier, chaque couche de bobines 2, 3 du capteur de courant est réalisée par impression en trois dimensions.

Les modes de réalisation des couches de bobines 2, 3 présentés ne sont pas limitatifs. Celles-ci pourront être réalisées par tout moyen technologique connu par l'homme de l'art.

Les deux couches de bobines 2, 3 sont préférentiellement fixées l'une à l'autre. Dans le cas d'une réalisation en technologie de circuit imprimé, des picots assurent la liaison électrique et le maintien mécanique des deux couches de bobines en vis-à-vis. L'assemblage peut aussi être réalisé par un procédé de collage ou de soudure.

L'ensemble des enroulements peut ainsi être réalisé sur un support monobloc, facile à manipuler. Cette technologie se prête particulièrement bien à la production industrielle en grande série à faible coût.

Le capteur de courant 1 de l'invention est particulièrement destiné à être intégré dans un appareil de mesure de courant ou de puissance ou d'énergie électrique.

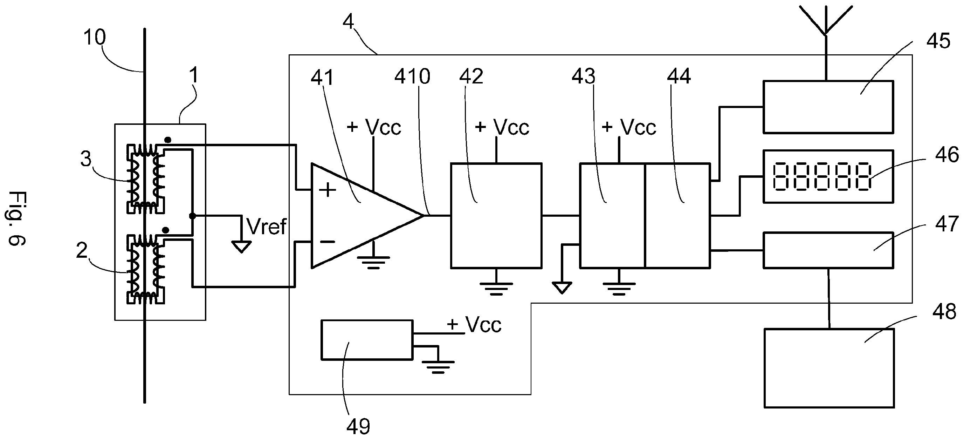

La figure 6 représente un schéma bloc d'un tel appareil de mesure. Chaque première couche de bobines 2 et seconde couche de bobines 3 possède une entrée de polarité négative et une sortie de polarité positive. Chacune des sorties de polarité positive est marquée d'un point sur la figure 6. L'entrée de polarité négative d'une couche de bobines correspond à l'extrémité d'une première spire bobinée dans le sens du bobinage, la sortie de polarité positive d'une couche de bobines correspond à l'extrémité d'une dernière spire bobinée dans le sens du bobinage.

La sortie de polarité positive de la première couche de bobines 2 est reliée électriquement avec l'entrée de polarité négative de la seconde couche de bobines 3. Cette liaison équipotentielle est préférentiellement connectée à un potentiel de référence Vref du circuit de mesure 4.

L'entrée de polarité négative de la première couche de bobines 2 est reliée électriquement à une entrée de polarité négative d'un amplificateur 41 préférentiellement de type différentiel, la sortie de polarité positive de la seconde couche de bobines 3 est reliée électriquement à une entrée de polarité positive de l'amplificateur 41. L'amplificateur 41 effectue l'amplification de la différence de tension mesurée entre son entrée de polarité positive et son entrée de polarité négative par rapport au potentiel de référence Vref. Le signal 410 en sortie de l'amplificateur différentiel 41 est intégré par un circuit intégrateur 42 puis converti par un convertisseur analogique numérique 43 en une grandeur numérique traitée par une unité de calcul à microprocesseur 44. Cette unité de calcul effectue les calculs adaptés pour mettre à disposition de l'utilisateur la valeur du courant circulant dans le conducteur électrique 10, par exemple sous forme d'une valeur affichée sur un afficheur 46 ou communiquée au moyen d'un module de communication radio 45 ou filaire 47 vers une unité de traitement 48 extérieure à l'appareil de mesure 4. Les différents modules 41 à 44 constituent des circuits de traitement connectés au capteur de courant 1 adaptés pour recevoir au moins un signal représentatif du courant circulant dans le conducteur de courant 10. Les différents modules 41 à 48 sont alimentés par une alimentation 49 fournissant une tension Vcc. L'alimentation 49 peut prélever son énergie soit sur le conducteur de courant 10 soit par une source externe indépendante. D'autres modes de réalisation pour le traitement de la tension délivrée par les bobines 2 et 3 peuvent être envisagés, par exemple par un ou plusieurs circuits mettant en oeuvre un traitement analogique des signaux.

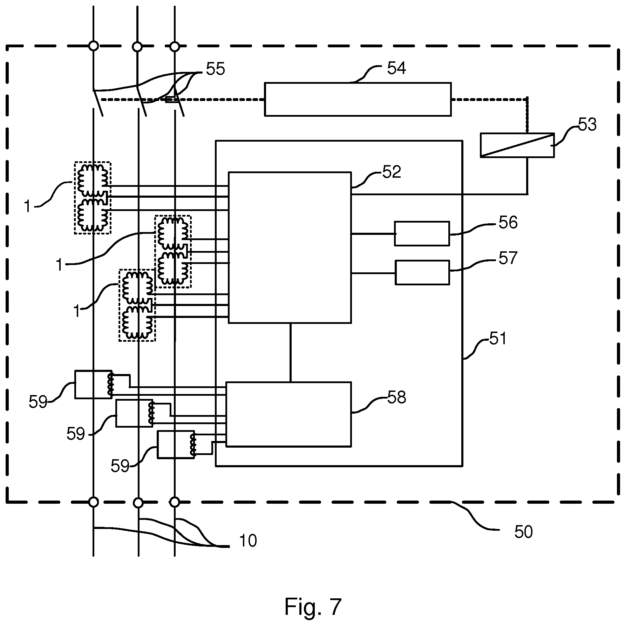

Plusieurs capteurs de courant 1 de l'invention peuvent aussi être intégrés dans un dispositif de coupure tel qu'un disjoncteur 50 équipé d'un déclencheur électrique 51 comme représenté en figure 7. Un disjoncteur est généralement installé sur un réseau triphasé et comporte trois lignes de courant 10 correspondant à chacune des phases du réseau électrique. Une quatrième ligne de courant peut être utilisée comme conducteur de neutre. Un capteur de courant 1 entoure chacun des conducteurs de courant 10. Un déclencheur électrique 51 comporte un ou plusieurs circuits de traitement 52 connectés audits capteurs de courant 1 et adaptés pour recevoir au moins un signal représentatif du courant circulant dans chacun des conducteurs de courant 10. Le disjoncteur 50 comporte en outre un mécanisme d'ouverture de contacts électriques 54, ledit mécanisme étant relié au déclencheur par un relais 53 pour ouvrir les contacts électriques 55. Le disjoncteur 50 comporte aussi un module d'affichage 56 permettant d'afficher des mesures et des indications élaborées par les circuits de traitement et un module de communication 57 permettant de transmettre les mesures et les indications par liaison radio ou filaire.

Un module d'alimentation 58 utilisant l'énergie prélevée par des capteurs d'alimentation 59 sur les conducteurs de courant 10 fournit en énergie les différents modules constituant le déclencheur électrique 51.

Plusieurs modes de réalisation industrielle des capteurs 1 sont possibles pour une implantation dans un appareil de mesure ou dans un disjoncteur triphasé afin de favoriser la production industrielle en grande série tout en garantissant un très bon alignement des couches de bobines 2 et 3 l'une par rapport à l'autre et une très bonne précision de réalisation des bobines :
- une première variante consiste à réaliser la première couche de bobines 2 de tous les capteurs au moyen d'un circuit imprimé portant également tout ou partie des circuits de traitement 52 et à réaliser chaque couche de bobines 3 de chaque capteur 1 au moyen d'un circuit imprimé indépendant,
- une seconde variante pour laquelle chaque capteur 1 est réalisé au moyen d'un unique circuit imprimé comprenant au moins quatre couches de haute qualité d'impression, deux couches étant destinées à la couche de bobine 2, les deux autres couches étant destinées à la couche de bobine 3, et
- une troisième variante pour laquelle un seul circuit imprimé, comportant au moins quatre couches conductrices de haute qualité d'impression, est utilisé pour intégrer les couches de bobines 2, 3 de tous les capteurs 1 ainsi que tout ou partie des circuits de traitement 52.

Les connexions entre les différentes couches conductrices sont réalisées au moyen de liaisons appelées « vias ». Ces liaisons ont généralement un accès sur les faces externes du circuit imprimé mais elles peuvent aussi être totalement aveugles (« blind vias » en anglais) afin de garder la planéité et la parfaite similitude des couches internes des capteurs 1 et garantir ainsi la précision de mesure. Dans tous ces modes de réalisation, les circuits imprimés comportent les évidements nécessaires au passage des lignes de courant 10.

Le capteur de courant 1 de l'invention est particulièrement adapté pour une implantation dans un appareil de mesure ou dans un appareil de protection ou de commande des circuits électriques en milieu industriel puisqu'il peut être réalisé de façon économique, son implantation est compacte, bien adaptée à la forme du disjoncteur 50 et procure une excellente précision de mesure et une grande insensibilité aux champs électromagnétiques externes grâce au pas de bobinage constant sur toute la longueur des bobines 2, 3.

## Revendications

1. Capteur de courant de type Rogowski comportant une première couche de bobines (2) et une seconde couche de bobines (3) susceptibles d'entourer un conducteur de courant (10) pour effectuer une mesure d'un courant circulant dans ledit conducteur,
- la première couche de bobines (2) comportant plusieurs enroulements (21, 22, 23, 24) reliés entre eux, chaque enroulement ayant un axe longitudinal (X1, X2, X3, X4) disposé dans un premier plan P1 et des spires sensiblement perpendiculaires audit axe, le croisement des axes formant des zones d'angle correspondant aux sommets d'un premier polygone (200) dans ledit premier plan (P1),
- la seconde couche de bobines (3) comportant plusieurs enroulements (31, 32, 33, 34) reliés entre eux, chaque enroulement ayant un axe longitudinal (Y1, Y2, Y3, Y4) disposé dans un second plan P2, parallèle au premier plan P1, et des spires sensiblement perpendiculaires audit axe, le croisement des axes formant des zones d'angle correspondant aux sommets d'un second polygone (300) dans ledit second plan (P2),
- les premier (200) et second polygones (300) étant placés en vis-à-vis de telle sorte que chaque zone d'angle du premier polygone (200) est respectivement située en vis-à-vis de chaque zone d'angle correspondante du second polygone (300),
**caractérisé en ce que**
dans chaque zone d'angle (201, 202, 203, 204), l'orientation des spires de l'enroulement (21, 22, 23, 24) de la première couche de bobines (2) est différente de l'orientation des spires de l'enroulement (31, 32, 33, 34) de la seconde couche de bobines (3) dans la zone d'angle (301, 302, 303, 304) en vis-à-vis.

2. Capteur de courant selon la revendication 1 **caractérisé en ce que** chaque zone d'angle (201, 202, 203, 204, 301, 302, 303, 304) est occupée par une extrémité d'un seul enroulement et qu'une extrémité d'un enroulement adjacent s'étend sensiblement jusqu'à un côté de l'enroulement occupant ladite zone d'angle.

3. Capteur de courant selon la revendication 2 **caractérisé en ce que** l' axe (X1, X2, X3, X4) de chaque enroulement (21, 22, 23, 24) de la première couche de bobines (2) selon chaque côté (205, 206, 207, 208) du premier polygone est parallèle à l'axe (Y1, Y2, Y3, Y4) de chaque enroulement en vis-à-vis (31, 32, 33, 34) de la seconde couche de bobines (3) selon chaque côté (305, 306, 307, 308) du second polygone (300).

4. Capteur de courant selon l'une des revendications précédentes **caractérisé en ce que** les enroulements (21, 22, 23, 24) de la première couche de bobines (2) sont reliés en série et les enroulements (31, 32, 33, 34) de la seconde couche de bobines (3) sont reliés en série.

5. Capteur de courant selon l'une des revendications précédentes **caractérisé en ce que** le sens de bobinage des enroulements (21, 22, 23, 24) de la première couche de bobines (2) est inversé par rapport au sens de bobinage des enroulements (31, 32, 33, 34) de la seconde couche de bobines (3).

6. Capteur de courant selon l'une des revendications précédentes **caractérisé en ce que** la forme des premier (200) et second (300) polygones est un rectangle ou un carré.

7. Capteur de courant selon la revendication 6 **caractérisé en ce que** dans chaque zone d'angle (201, 202, 203, 204), les spires de l'enroulement (21, 22, 23, 24) de la première couche de bobines (2) sont orientées sensiblement à angle droit par rapport aux spires de l'enroulement (31, 32, 33, 34) de la seconde couche de bobines (3) dans la zone d'angle en vis-à-vis.

8. Capteur de courant selon l'une des revendications 1 à 7 **caractérisé en ce que** les bobines (2, 3) sont réalisées selon la technique du circuit imprimé.

9. Capteur de courant selon l'une des revendications 1 à 7 **caractérisé en ce que** les bobines (2, 3) sont réalisées par un dépôt de matériau conducteur de l'électricité sur un support isolant au moyen d'une technique de sérigraphie.

10. Capteur de courant selon l'une des revendications 1 à 7 **caractérisé en ce que** les bobines (2, 3) sont réalisés selon une technique d'impression en trois dimensions.

11. Appareil de mesure de puissance ou d'énergie électrique comportant au moins un capteur de courant relié à au moins un circuit de traitement du signal représentatif du courant circulant dans au moins un conducteur de courant 10, **caractérisé en ce qu'**il comporte au moins un capteur de courant 1 selon l'une des revendications 1 à 10.

12. Appareil de mesure de puissance ou d'énergie électrique selon la revendication 11 caractérisé en ce :
- une première extrémité de la première couche de bobines (2) est reliée à un potentiel de référence (Vref) dudit appareil de mesure,
- une seconde extrémité de la première couche de bobines (2) est reliée à une première entrée d'un amplificateur (41),
- une première extrémité la seconde couche de bobines (3) est reliée audit potentiel de référence (Vref) dudit appareil de mesure et
- une seconde extrémité de la seconde couche de bobines (3) est reliée à une seconde entrée dudit l'amplificateur (41).

13. Déclencheur électrique **caractérisé en ce qu'**il comprend au moins un capteur de courant 1 selon l'une des revendications 1 à 10, et au moins un circuit de traitement connecté audit au moins un capteur de courant 1 pour recevoir au moins un signal représentatif du courant circulant dans au moins un conducteur de courant 10.

14. Dispositif de coupure **caractérisé en ce qu'**il comporte un déclencheur électrique selon la revendication 13, un mécanisme d'ouverture de contacts électriques, ledit mécanisme étant relié au déclencheur pour ouvrir les contacts électriques.

## Patentansprüche

1. Stromfühler vom Typ Rogowski, umfassend eine erste Spulenschicht (2) und eine zweite Spulenschicht (3), die geeignet sind, einen Stromleiter (10) zu umgeben, um eine Messung eines in dem Leiter zirkulierenden Stroms durchzuführen,
- wobei die erste Spulenschicht (2) mehrere Wicklungen (21, 22, 23, 24), die miteinander verbunden sind, umfasst, wobei jede Wicklung eine Längsachse (X1, X2, X3, X4), die in einer ersten Ebene P1 angeordnet ist, und Windungen im Wesentlichen senkrecht auf die Achse hat, wobei die Kreuzung der Achsen Winkelzonen bildet, die den Scheiteln eines ersten Vielecks (200) in der ersten Ebene (P1) entsprechen,
- wobei die zweite Spulenschicht (3) mehrere Wicklungen (31, 32, 33, 34), die miteinander verbunden sind, umfasst, wobei jede Wicklung eine Längsachse (Y1, Y2, Y3, Y4), die in einer zweiten Ebene P2 parallel zur ersten Ebene P1 angeordnet ist, und Windungen im Wesentlichen senkrecht auf die Achse hat, wobei die Kreuzung der Achsen Winkelzonen bildet, die den Scheiteln eines zweiten Vielecks (300) in der zweiten Ebene (P2) entsprechen,
- wobei die ersten (200) und zweiten Vielecke (300) einander gegenüberliegend angeordnet sind, so dass jede Winkelzone des ersten Vielecks (200) jeweils gegenüber jeder entsprechenden Winkelzone des zweiten Vielecks (300) angeordnet ist,
**dadurch gekennzeichnet, dass**
in jeder Winkelzone (201, 202, 203, 204) die Ausrichtung der Windungen der Wicklung (21, 22, 23, 24) der ersten Spulenschicht (2) zur Ausrichtung der Windungen der Wicklung (31, 32, 33, 34) der zweiten Spulenschicht (3) in der gegenüberliegenden Winkelzone (301, 302, 303, 304) unterschiedlich ist.

2. Stromfühler nach Anspruch 1, **dadurch gekennzeichnet, dass** jede Winkelzone (201, 202, 203, 204, 301, 302, 303, 304) von einem Ende von nur einer Wicklung eingenommen ist, und dass sich ein Ende einer angrenzenden Wicklung im Wesentlichen bis zu einer Seite der Wicklung, die die Winkelzone einnimmt, erstreckt.

3. Stromfühler nach Anspruch 2, **dadurch gekennzeichnet, dass** die Achse (X1, X2, X3, X4) jeder Wicklung (21, 22, 23, 24) der ersten Spulenschicht (2) entlang jeder Seite (205, 206, 207, 208) des ersten Vielecks parallel zur Achse (Y1, Y2, Y3, Y4) jeder gegenüberliegenden Wicklung (31, 32, 33, 34) der zweiten Spulenschicht (3) entlang jeder Seite (305, 306, 307, 308) des zweiten Vielecks (300) ist.

4. Stromfühler nach einem der vorhergehenden Ansprüche, **dadurch gekennzeichnet, dass** die Wicklungen (21, 22, 23, 24) der ersten Spulenschicht (2) in Serie verbunden sind, und die Wicklungen (31, 32, 33, 34) der zweiten Spulenschicht (3) in Serie verbunden sind.

5. Stromfühler nach einem der vorhergehenden Ansprüche, **dadurch gekennzeichnet, dass** die Wickelrichtung der Wicklungen (21, 22, 23, 24) der ersten Spulenschicht (2) zur Wickelrichtung der Wicklungen (31, 32, 33, 34) der zweiten Spulenschicht (3) umgekehrt ist.

6. Stromfühler nach einem der vorhergehenden Ansprüche, **dadurch gekennzeichnet, dass** die Form der ersten (200) und zweiten (300) Vielecke ein Rechteck oder ein Quadrat ist.

7. Stromfühler nach Anspruch 6, **dadurch gekennzeichnet, dass** in jeder Winkelzone (201, 202, 203, 204) die Windungen der Wicklung (21, 22, 23, 24) der ersten Spulenschicht (2) im Wesentlichen im rechten Winkel zu den Windungen der Wicklung (31, 32, 33, 34) der zweiten Spulenschicht (3) in der gegenüberliegenden Winkelzone ausgerichtet sind.

8. Stromfühler nach einem der Ansprüche 1 bis 7, **dadurch gekennzeichnet, dass** die Spulen (2, 3) nach der Technik der gedruckten Schaltung hergestellt sind.

9. Stromfühler nach einem der Ansprüche 1 bis 7, **dadurch gekennzeichnet, dass** die Spulen (2, 3) durch ein Aufbringen von elektrisch leitendem Material auf einen Isolierträger mit Hilfe einer Siebdrucktechnik hergestellt sind.

10. Stromfühler nach einem der Ansprüche 1 bis 7, **dadurch gekennzeichnet, dass** die Spulen (2, 3) nach einer dreidimensionalen Drucktechnik hergestellt sind.

11. Gerät zum Messen von Leistung oder elektrischer Energie, umfassend mindestens einen Stromfühler, der mit mindestens einer Schaltung zur Bearbeitung des für den in mindestens einem Stromleiter 10 zirkulierenden Stroms repräsentativen Signals verbunden ist, **dadurch gekennzeichnet, dass** es mindestens einen Stromfühler 1 nach einem der Ansprüche 1 bis 10 umfasst.

12. Gerät zum Messen von Leistung oder elektrischer Energie nach Anspruch 11, **dadurch gekennzeichnet, dass**:
- ein erstes Ende der ersten Spulenschicht (2) mit einem Referenzpotential (Vref) des Messgeräts verbunden ist,
- ein zweites Ende der ersten Spulenschicht (2) mit einem ersten Eingang eines Verstärkers (41) verbunden ist,
- ein erstes Ende der zweiten Spulenschicht (3) mit dem Referenzpotential (Vref) des Messgeräts verbunden ist,
- ein zweites Ende der zweiten Spulenschicht (3) mit einem zweiten Eingang des Verstärkers (41) verbunden ist.

13. Elektrischer Auslöser, **dadurch gekennzeichnet, dass** er mindestens einen Stromfühler 1 nach einem der Ansprüche 1 bis 10 und mindestens eine Bearbeitungsschaltung, die an den mindestens einen Stromfühler 1 angeschlossen ist, um mindestens ein für den in mindestens einem Stromleiter 10 zirkulierenden Strom repräsentatives Signal zu empfangen, umfasst.

14. Unterbrechungsvorrichtung, **dadurch gekennzeichnet, dass** es einen elektrischen Auslöser nach Anspruch 13, einen Öffnungsmechanismus von elektrischen Kontakten umfasst, wobei der Mechanismus mit dem Auslöser verbunden ist, um die elektrischen Kontakte zu öffnen.

## Claims

1. Current sensor of Rogowski type comprising a first layer of coils (2) and a second layer of coils (3) able to surround a current conductor (10) so as to perform a measurement of a current flowing in the said conductor,
- the first layer of coils (2) comprising a plurality of windings (21, 22, 23, 24) linked together, each winding having a longitudinal axis (X1, X2, X3, X4) arranged in a first plane P1 and turns that are substantially perpendicular to the said axis, the crossover of the axes forming corner zones corresponding to the vertices of a first polygon (200) in the said first plane (P1),
- the second layer of coils (3) comprising a plurality of windings (31, 32, 33, 34) linked together, each winding having a longitudinal axis (Y1, Y2, Y3, Y4) arranged in a second plane P2, parallel to the first plane P1, and turns that are substantially perpendicular to the said axis, the crossover of the axes forming corner zones corresponding to the vertices of a second polygon (300) in the said second plane (P2),
- the first (200) and second polygons (300) being placed facing one another such that each corner zone of the first polygon (200) is respectively situated facing each corresponding corner zone of the second polygon (300),
**characterized in that**
in each corner zone (201, 202, 203, 204), the orientation of the turns of the winding (21, 22, 23, 24) of the first layer of coils (2) is different from the orientation of the turns of the winding (31, 32, 33, 34) of the second layer of coils (3) in the facing corner zone (301, 302, 303, 304).

2. Current sensor according to Claim 1, **characterized in that** each corner zone (201, 202, 203, 204, 301, 302, 303, 304) is occupied by an end of a single winding and that an end of an adjacent winding extends substantially as far as a side of the winding occupying the said corner zone.

3. Current sensor according to Claim 2, **characterized in that** the axis (X1, X2, X3, X4) of each winding (21, 22, 23, 24) of the first layer of coils (2) along each side (205, 206, 207, 208) of the first polygon is parallel to the axis (Y1, Y2, Y3, Y4) of each facing winding (31, 32, 33, 34) of the second layer of coils (3) along each side (305, 306, 307, 308) of the second polygon (300).

4. Current sensor according to one of the preceding claims, **characterized in that** the windings (21, 22, 23, 24) of the first layer of coils (2) are linked in series and the windings (31, 32, 33, 34) of the second layer of coils (3) are linked in series.

5. Current sensor according to one of the preceding claims, **characterized in that** the direction of coiling of the windings (21, 22, 23, 24) of the first layer of coils (2) is reversed with respect to the direction of coiling of the windings (31, 32, 33, 34) of the second layer of coils (3).

6. Current sensor according to one of the preceding claims, **characterized in that** the shape of the first (200) and second (300) polygons is a rectangle or a square.

7. Current sensor according to Claim 6, **characterized in that** in each corner zone (201, 202, 203, 204), the turns of the winding (21, 22, 23, 24) of the first layer of coils (2) are oriented substantially at right angles with respect to the turns of the winding (31, 32, 33, 34) of the second layer of coils (3) in the facing corner zone.

8. Current sensor according to one of Claims 1 to 7, **characterized in that** the coils (2, 3) are produced according to the printed circuit technique.

9. Current sensor according to one of Claims 1 to 7, **characterized in that** the coils (2, 3) are produced by depositing an electrically conducting material on an insulating support by means of a silk-screen printing technique.

10. Current sensor according to one of Claims 1 to 7, **characterized in that** the coils (2, 3) are produced according to a three-dimensional printing technique.

11. Apparatus for measuring electrical power or energy comprising at least one current sensor linked to at least one circuit for processing the signal representative of the current flowing in at least one current conductor 10, **characterized in that** it comprises at least one current sensor 1 according to one of Claims 1 to 10.

12. Apparatus for measuring electrical power or energy according to Claim 11, **characterized in that**:
- a first end of the first layer of coils (2) is linked to a reference potential (Vref) of the said measuring apparatus,
- a second end of the first layer of coils (2) is linked to a first input of an amplifier (41),
- a first end of the second layer of coils (3) is linked to the said reference potential (Vref) of the said measuring apparatus and
- a second end of the second layer of coils (3) is linked to a second input of the said amplifier (41).

13. Electrical trip switch **characterized in that** it comprises at least one current sensor 1 according to one of Claims 1 to 10, and at least one processing circuit connected to the said at least one current sensor 1 so as to receive at least one signal representative of the current flowing in at least one current conductor 10.

14. Isolating device **characterized in that** it comprises an electrical trip switch according to Claim 13, a mechanism for opening electrical contacts, the said mechanism being linked to the trip switch so as to open the electrical contacts.
